(19) **Europäisches Patentamt / European Patent Office / Office européen des brevets**

(11) **EP 3 343 577 A1**

(12) # EUROPEAN PATENT APPLICATION

(43) Date of publication:
04.07.2018 Bulletin 2018/27

(51) Int Cl.:
*H01G 9/20* (2006.01)

(21) Application number: 17211133.8

(22) Date of filing: 29.12.2017

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**MA MD TN**

(30) Priority: 30.12.2016 KR 20160183921
13.10.2017 KR 20170133494

(71) Applicant: **Dongjin Semichem Co., Ltd**
**Incheon 22824 (KR)**

(72) Inventors:
• **KIM, Yong Su**
**13486 Seongnam-si (KR)**
• **KIM, Jong Bok**
**13486 Seongnam-si (KR)**
• **YANG, Hoe Taek**
**13486 Seongnam-si (KR)**
• **SHIN, Kyusoon**
**13486 Seongnam-si (KR)**

(74) Representative: **Grünecker Patent- und Rechtsanwälte**
**PartG mbB**
**Leopoldstraße 4**
**80802 München (DE)**

(54) **DYE SENSITIZED SOLAR CELL MODULE AND DYE SENSITIZED SOLAR CELL COMPRISING THE SAME**

(57) The present invention relates to a dye-sensitized solar cell module, and more particularly, to a dye-sensitized solar cell module capable of minimizing a burst phenomenon of the dye-sensitized solar cell module caused by the bubbles by preventing occurrence of bubbles in an electrolyte solution, and securing reliability by preventing separation of a dye adsorbed onto a oxide semiconductor, and a dye-sensitized solar cell including the same.

FIG. 1

EP 3 343 577 A1

**Description**

**[Technical Field]**

The present invention relates to a dye-sensitized solar cell module. More particularly, the present invention relates to a dye-sensitized solar cell module capable of securing reliability by preventing occurrence of bubbles in an electrolyte solution, and a dye-sensitized solar cell including the same.

**[Background Art]**

Contents described below merely provide background information related to the present invention and do not constitute the conventional art.

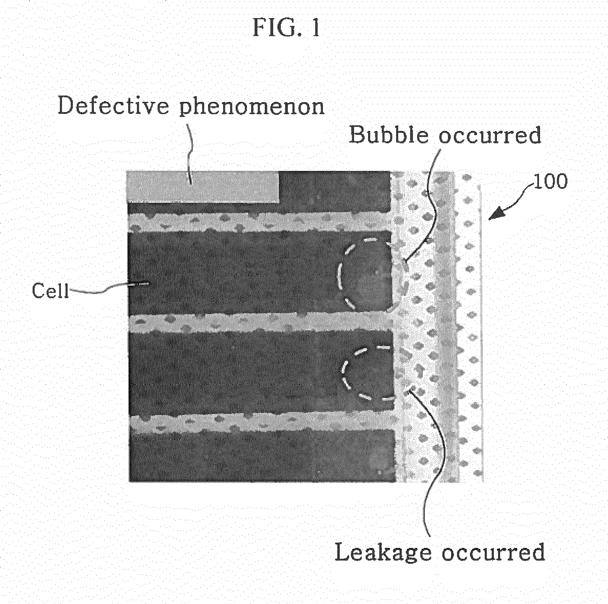

A dye-sensitized solar cell module has a structure in which an electrolyte solution is positioned between two glass substrates, i.e., a working electrode and a counter electrode. The working electrode substrate has a structure in which a porous oxide semiconductor including a dye adsorbed thereonto is deposited. When an electrolyte solution is not sufficiently filled between pores of porous oxide semiconductor (wherein a size of the pore is about 20 nm in diameter), bubbles occur in a unit cell electrolyte solution of a module 100 including a plurality of unit cells, and after an injection of the electrolyte solution is completed, a temperature in the module is increased when performing high-temperature compressing during a sealing process for sealing an electrolyte solution injection path with a sealant, and as a result, as shown in FIG. 1, the module is burst due to volume expansion of the electrolyte solution, and thus, the electrolyte solution inside the module partially flows out through the electrolyte solution injection path. The electrolyte solution that flows out leads to deterioration of interfacial adhesion of the sealant, causes deterioration of the module of the dye-sensitized solar cell (deterioration of module characteristics), and thus, durability of the dye-sensitized solar cell is not possible to be secured without resolving the deterioration factors. Further, the bubbles around the porous oxide semiconductor desorb the dye adsorbed onto the porous oxide semiconductor, and thus, an efficiency of the dye-sensitized solar cell may be deteriorated, which may cause a problem in reliability.

**[DISCLOSURE]**

**[Technical Problem]**

The present invention has been made in an effort to provide a dye-sensitized solar cell module having advantages of securing reliability by preventing occurrence of bubbles in an electrolyte solution, and a dye-sensitized solar cell including the same.

**[Technical Solution]**

An exemplary embodiment of the present invention provides a dye-sensitized solar cell module including: a plurality of unit cells including a working electrode, a counter electrode, and an electrolyte solution interposed between the working electrode and the counter electrode, wherein the number of bubbles included in the unit cell is 10 or less.

Another embodiment of the present invention provides a dye-sensitized solar cell module including: a plurality of unit cells including a working electrode, a counter electrode, and an electrolyte solution interposed between the working electrode and the counter electrode, wherein a volume of the unit cell is $V_1$, a volume of the electrolyte solution interposed in the unit cell is $V_2$, and $V_1$ and $V_2$ satisfy Equation 1 below:

$$[\text{Equation 1}]$$

$$1 < V_2/V_1 \leq 1.5.$$

Another embodiment of the present invention provides a dye-sensitized solar cell module including: a plurality of unit cells including a working electrode, a counter electrode, and an electrolyte solution interposed between the working electrode and the counter electrode, wherein the counter electrode includes an electrolyte solution injection path, the unit cell further includes a cover glass covering the electrolyte solution injection path, the electrolyte solution remains within a range of two times a diameter of the electrolyte solution injection path, and the counter electrode and the cover glass are in contact with a sealant in a region other than a region where the electrolyte solution remains.

**[Advantageous Effects]**

According to the present invention, it is possible to minimize a burst phenomenon of the dye-sensitized solar cell module caused by the bubbles by preventing occurrence of bubbles in an electrolyte solution of the dye-sensitized solar cell module, and to secure reliability by preventing separation of a dye adsorbed onto the porous oxide semiconductor.

**[Description of the Drawings]**

FIG. 1 is an image illustrating defects in which an electrolyte solution flows out due to bubbles in a dye-sensitized solar cell module.

FIG. 2 is a view showing a dye-sensitized solar cell module in which bubbles are absent at room temperature according to an exemplary embodiment of the present invention.

FIG. 3 is an image showing that the bubbles occurring in the electrolyte solution are absent in the dye-sensitized solar cell module according to the exemplary embodiment of the present invention after the module is stored in an oven at 85°C for 2 hours.

FIG. 4 is an image showing a result of a drilling test to confirm whether it is the dye-sensitized solar cell module according to the exemplary embodiment of the present invention.

FIG. 5 is a view showing injection of the electrolyte solution into the dye-sensitized solar cell module according to the exemplary embodiment of the present invention.

FIG. 6 is a view showing a step of attaching and sealing an electrolyte solution injection path of the dye-sensitized solar cell module according to the exemplary embodiment of the present invention with a cover glass to which a sealant is bonded, using a heating bar.

**[Mode for Invention]**

In the following detailed description, only certain exemplary embodiments of the present invention have been shown and described, simply by way of illustration. As those skilled in the art would realize, the described embodiments may be modified in various different ways, all without departing from the spirit or scope of the present invention.

In addition, unless explicitly described to the contrary, the word "comprise" and variations such as "comprises" or "comprising", will be understood to imply the inclusion of stated elements but not the exclusion of any other elements.

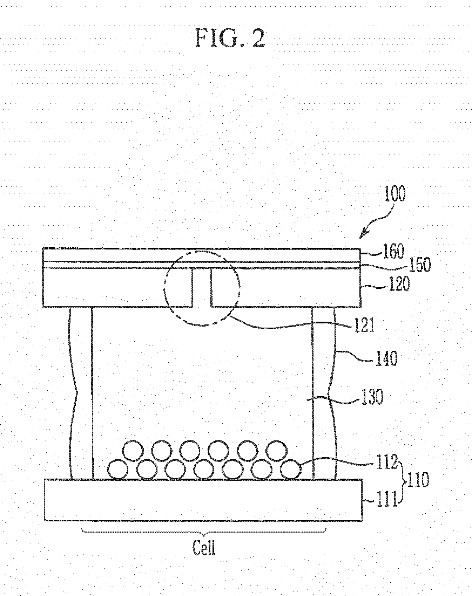

FIG. 2 is a view showing a dye-sensitized solar cell module 100 according to an exemplary embodiment of the present invention. Matters relating to construction and manufacture of known dye-sensitized solar cell modules may be applied to parts that are not described in the following description

The dye-sensitized solar cell module 100 according to an exemplary embodiment of the present invention includes a working electrode 110, a counter electrode 120, an Ag electrode 140 that connects the working electrode 110 to the counter electrode 120, and an electrolyte solution 130 filled in a space between the working electrode 110 and the counter electrode 120.

In detail, the working electrode 110 may be formed by depositing a oxide semiconductor 112 onto which a dye (not shown) is adsorbed on a substrate 111 coated with a conductive film.

The substrate 111 is a transparent soda lime glass, and may be a conductive substrate through which an electric current flows due to FTO coating on a surface, and serves as a moving path of electrons.

The oxide semiconductor 112 deposited on the substrate 111 is composed of a porous metal oxide, and transmits the electrons generated when the dye adsorbed onto the porous metal oxide receives light to the substrate 111 of the working electrode 110.

The counter electrode 120 is positioned opposite to the working electrode 110, and may be formed by forming a catalyst layer using platinum after TCO coating on a transparent soda lime glass. The counter electrode 120 serves to transmit electrons to the dye.

The Ag electrode 140 serves to electrically connect the working electrode and the counter electrode, and the Ag electrode may be formed by performing a screen printing process using an Ag paste on the working electrode 110 and the counter electrode 120.

The electrolyte solution 130 serves to allow the electrons generated in the dye to flow to an external conducting wire through the working electrode 110, and to reduce the dye of the working electrode through the counter electrode 120 again, and may be formed of an iodine material.

The dye-sensitized solar cell module 100 according to an exemplary embodiment of the present invention may include the plurality of unit cells, and the number of bubbles included in the unit cell may be 10 or less, preferably, 5 or less, and more preferably, the bubbles may be absent.

Accordingly, the dye-sensitized solar cell module 100 of the present invention may prevent separation of the dye from the inside of the module due to the bubbles and a burst phenomenon of the module.

A volume of the electrolyte solution interposed in the unit cell of the dye-sensitized solar cell module 100 according to an exemplary embodiment of the present invention may be larger than a volume at which the electrolyte solution of the dye-sensitized solar cell is filled at room temperature at 1 atmospheric pressure. Specifically, since the electrolyte solution 130 is injected into the cell of the module 100 through the electrolyte solution injection path 121 by simultaneously applying two or more processes of forming a vacuum, adding pressure, or changing a temperature, the volume of the electrolyte solution 130 filled in the cell may be larger than the volume of the electrolyte solution filled in the cell of the dye-sensitized solar cell module 100 at room temperature at 1 atmospheric pressure.

Equation that specifically expresses the above description is as follows. When the volume of the unit cell of the module 100 designed at room temperature at 1 atmospheric pressure is $V_1$ and the volume of the electrolyte solution interposed in the unit cell of the module 100 according to an exemplary embodiment of the present invention is $V_2$, $V_1$ and $V_2$ satisfy Equation 1 below:

$$[\text{Equation 1}]$$

$$1 < V_2/V_1 \leq 1.5.$$

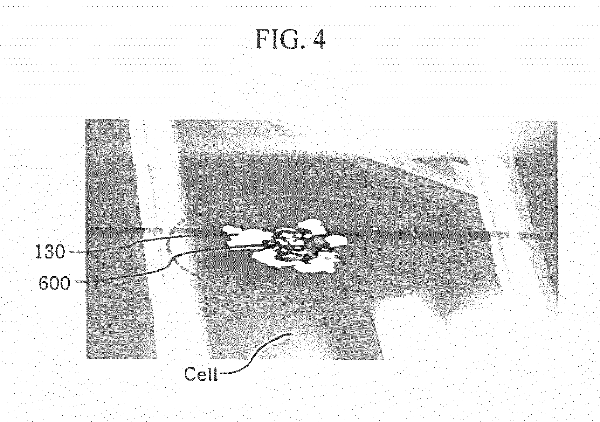

That is, since the dye-sensitized solar cell module 100 according to an exemplary embodiment of the present invention is filled with the electrolyte solution by simultaneously applying two or more processes of forming a vacuum, adding pressure, or changing a temperature, an internal pressure exists in the cell. Accordingly, as shown in FIG. 4, at the time of performing a drilling test in which a hole 600 is drilled through a specific place in the cell, the electrolyte solution 130 is spurted like popcorn to the outside as indicated by circle.

The electrolyte solution 130 filled in the cell is filled at a density of 0.8 g/ml to 1.8 g/ml, and specifically has a density value of 1.2 g/ml.

When reviewing density values for each solvent type, an organic solvent electrolyte solution is filled at a density of 0.90 g/ml to 1.50 g/ml, an ionic liquid electrolyte solution is filled at a density of 1.15 g/ml to 1.75 g/ml, and a polymer organic solvent mixed electrolyte solution is filled at a density of 0.95 g/ml to 1.45 g/ml.

When the dye-sensitized solar cell module 100 according to an exemplary embodiment of the present invention is stored in an oven at 85°C for 2 hours, a size of the bubble occurring in the electrolyte solution 130 may be 5 mm or less, and the number of bubbles included in the unit cell may be 10 or less, specifically, the number of bubbles each having a size of 5 mm or less may be 5 or less, and more specifically, when the dye-sensitized solar cell module 100 is stored in an oven at 85°C for 2 hours, the bubbles occurring in the electrolyte solution 130 of the unit cell may be absent.

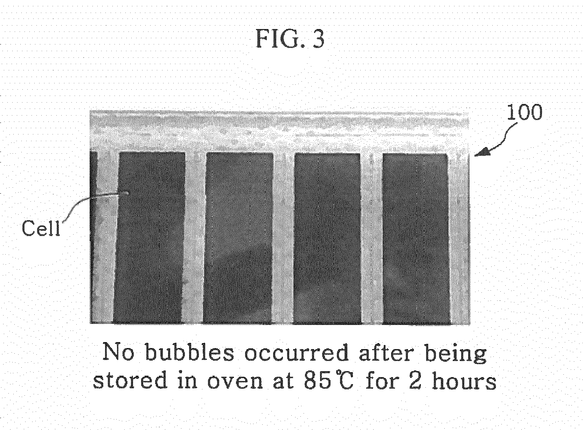

FIG. 3 is an image showing the dye-sensitized solar cell module 100 having a structure of FIG. 2 according to the exemplary embodiment of the present invention after the module 100 is stored in an oven at 85°C for 2 hours, which may be confirmed that the bubbles occurring in the electrolyte solution of the unit cell are absent.

Further, the dye-sensitized solar cell module according to an exemplary embodiment of the present invention may further include the electrolyte solution injection path 121 positioned at any part of the counter electrode 120, and a sealant 150 and a cover glass 160 for sealing the electrolyte solution injection path 121 in addition to the working electrode 110, the counter electrode 120, and the electrolyte solution 130.

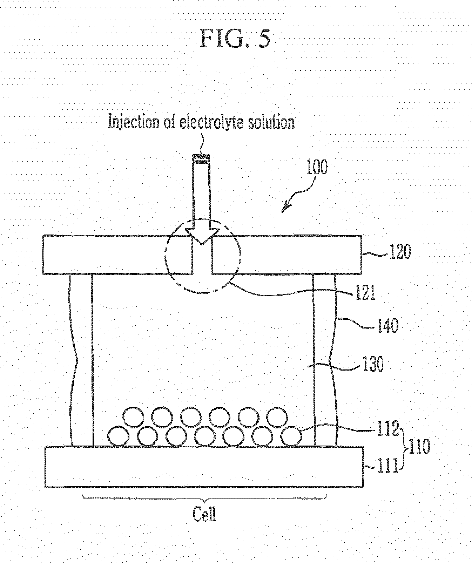

FIG. 5 is a view showing injection of the electrolyte solution, wherein the electrolyte solution injection path 121 may be positioned at any part of the counter electrode 120 for injecting the electrolyte solution 130 into the dye-sensitized solar cell module 100. The electrolyte solution injection path 121 may be formed as a passage having a diameter of 0.1 mm to 1 mm, or specifically, a passage having a diameter of 0.1 mm to 0.7 mm. The electrolyte solution is injected through the electrolyte solution injection path 121, and the electrolyte solution is sufficiently injected by applying a pressure in a vacuum state so that the bubbles do not occur during the injection process.

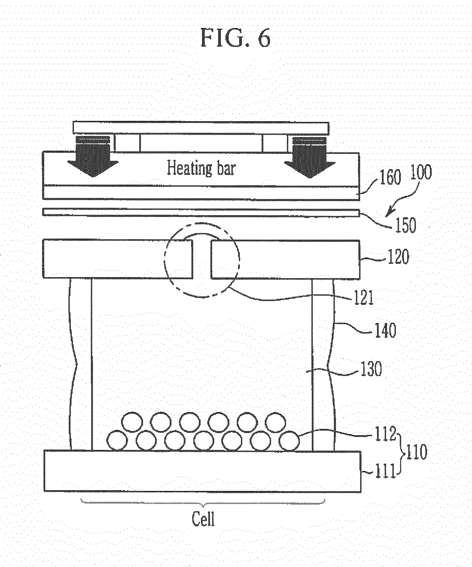

FIG. 6 shows the sealing step, wherein the electrolyte solution injection path 121 of the dye-sensitized solar cell module 100 is attached and sealed with the sealant 150 and the cover glass 160 using a heating bar.

The sealant 150 serves to adhere the counter electrode 120 having the electrolyte solution injection path 121 to the cover glass 160.

The cover glass 160 is a soda lime glass, and serves to seal the electrolyte solution injection path 121 so as to prevent leakage of the electrolyte solution.

Further, a small amount of the electrolyte solution 130 may remain between the counter electrode 120 and the sealant 150 since the electrolyte solution remaining at an inlet of the injection path 121 is not wiped when the filling is completed. At this time, the remaining electrolyte solution 130 remains within a range of two times a diameter of the electrolyte solution injection path 121, and the counter electrode 120 and the cover glass 160 are in direct contact with the sealant 150 in a region other than a region where the electrolyte solution 130 remains.

For example, the electrolyte solution 130 remains within 10 mm of a radius of the electrolyte solution injection path 121, and the sealant 150 and the cover glass 160 are positioned on the remaining electrolyte solution 130. When the diameter of the electrolyte solution injection path 121 is 0.1 mm to 1 mm, the electrolyte solution 130 may remain within the radius of 2 mm of the electrolyte solution injection path 121.

The dye-sensitized solar cell module of the present invention may minimize the burst phenomenon of the dye-sensitized solar cell module caused by the bubbles by preventing occurrence of the bubbles in the electrolyte solution, and may secure reliability by preventing separation of the dye adsorbed onto the oxide semiconductor.

Further, the present invention may manufacture a dye-sensitized solar cell including the solar cell module.

Example

In order to evaluate the performance of the dye-sensitized solar cell module according to the exemplary embodiment of the present invention, a comparison test of bubble occurrence was performed with a conventional dye-sensitized solar cell module.

The test was performed by measuring the number of bubbles and the size thereof occurring after storing the dye-sensitized solar cell module in an oven at 85°C for 2 hours according to the density of the electrolyte solution. In order to obtain the reliability of the test, the test was repeated 10 times and an average value thereof was described.

[Table 1]

| Electrolyte solution density (g/ml) | Test temperature | 1H | 2H | 24H or longer |
|---|---|---|---|---|
| 1.8 | 85°C | Size of 5 mm or less 5 or less of bubbles | Size of 5 mm or less 10 or less of bubbles | Size of 5 mm or less 10 or less of bubbles |
| 0.8 | 85°C | Size of 5 mm or less 5 or less of bubbles | Size of 5 mm or less 10 or less of bubbles | Size of 5 mm or less 10 or less of bubbles |
| 0.6 | 85°C | Size of 5 mm or less 10 or less of bubbles | Size of 5 mm or less 20 or less of bubbles | Burst of module sealing |
| 0.2 | 85°C | Size of 5 mm or less 15 or less of bubbles | Burst of module sealing | Burst of module sealing |

Referring to Table 1, the lower the density of the electrolyte solution, the more bubbles occurred. In some of the experiments, when the density was less than 0.8 g/ml, the module could not withstand the test and the sealing of the module was burst during the test.

The present invention has been described above with reference to preferred exemplary embodiments thereof. It will be appreciated by those skilled in the art that various modifications, changes, and substitutions can be made without departing from the essential characteristics of the present invention. Accordingly, the embodiments disclosed in the present invention and the accompanying drawings are used not to limit but to describe the spirit of the present invention. The scope of the present invention is not limited only to the embodiments and the accompanying drawings. The protection scope of the present invention must be analyzed by the appended claims and it should be analyzed that all spirits within a scope equivalent thereto are included in the appended claims of the present invention.

<Description of symbols>

100:    Dye-sensitized solar cell module
110:    Working electrode
111:    Working electrode substrate
112:    Oxide semiconductor onto which dye (not shown) is adsorbed.
120:    Counter electrode
121:    Electrolyte solution injection path
130:    Electrolyte solution

140:    Ag electrode
150:    Sealant
160:    Cover substrate

**Claims**

1. A dye-sensitized solar cell module comprising:

    a plurality of unit cells including a working electrode, a counter electrode, and an electrolyte solution interposed between the working electrode and the counter electrode,
    wherein the number of bubbles included in the unit cell is 10 or less.

2. The dye-sensitized solar cell module of claim 1, wherein:

    when the dye-sensitized solar cell module is stored in an oven at 85°C for 2 hours, a size of the bubble occurring in the electrolyte solution is 5 mm or less, and the number of bubbles included in the unit cell is 10 or less,
    in particular, when the dye-sensitized solar cell module is stored in an oven at 85°C for 2 hours, a size of bubble occurring in the electrolyte solution is 5 mm or less, and the number of bubbles included in the unit cell is 5 or less.

3. The dye-sensitized solar cell module of claim 1, wherein:

    the bubbles occurring in the unit cell are absent when the dye-sensitized solar cell module is stored in an oven at 85°C for 2 hours.

4. The dye-sensitized solar cell module of claim 1, wherein:

    a volume of the electrolyte solution interposed in the dye-sensitized solar cell module is larger than a volume at which the electrolyte solution of the dye-sensitized solar cell is filled at room temperature at 1 atmospheric pressure.

5. The dye-sensitized solar cell module of claim 1, wherein:

    the electrolyte solution filled in the dye-sensitized solar cell module has a density of 0.8 g/ml to 1.8 g/ml.

6. A dye-sensitized solar cell module comprising:

    a plurality of unit cells including a working electrode, a counter electrode, and an electrolyte solution interposed between the working electrode and the counter electrode,
    wherein a volume of the unit cell is $V_1$, a volume of the electrolyte solution interposed in the unit cell is $V_2$, and $V_1$ and $V_2$ satisfy Equation 1 below:

[Equation 1]

$$1 < V_2/V_1 \leq 1.5.$$

7. The dye-sensitized solar cell module of claim 6, wherein:

    the number of bubbles included in the unit cell is 10 or less.

8. The dye-sensitized solar cell module of claim 6, wherein:

    when the dye-sensitized solar cell module is stored in an oven at 85°C for 2 hours, a size of bubble occurring in the electrolyte solution is 5 mm or less, and the number of bubbles included in the unit cell is 10 or less,
    in particular, when the dye-sensitized solar cell module is stored in an oven at 85°C for 2 hours, a size of bubble occurring in the electrolyte solution is 5 mm or less, and the number of bubbles included in the unit cell is 5 or less .

9. The dye-sensitized solar cell module of claim 6, wherein:

   bubbles occurring in the unit cell are absent when the dye-sensitized solar cell module is stored in an oven at 85°C for 2 hours.

10. A dye-sensitized solar cell module comprising:

   a plurality of unit cells including a working electrode, a counter electrode, and an electrolyte solution interposed between the working electrode and the counter electrode,
   wherein the counter electrode includes an electrolyte solution injection path,
   the unit cell further includes a cover glass covering the electrolyte solution injection path,
   the electrolyte solution remains within a range of two times a diameter of the electrolyte solution injection path, and
   the counter electrode and the cover glass are in contact with a sealant in a region other than a region where the electrolyte solution remains.

11. The dye-sensitized solar cell module of claim 10, wherein:

   the electrolyte solution remains within a radius of 10 mm of the electrolyte solution injection path,
   and/or the sealant and the cover glass are positioned on the electrolyte solution in the region where the electrolyte solution remains.

12. The dye-sensitized solar cell module of claim 10, wherein:

   the number of bubbles included in the unit cell is 10 or less.

13. The dye-sensitized solar cell module of claim 10, wherein:

   when the dye-sensitized solar cell module is stored in an oven at 85°C for 2 hours, a size of bubble occurring in the electrolyte solution is 5 mm or less, and the number of bubbles included in the unit cell is 10 or less,
   in particular, when the dye-sensitized solar cell module is stored in an oven at 85°C for 2 hours, a size of bubble occurring in the electrolyte solution is 5 mm or less, and the number of bubbles included in the unit cell is 5 or less.

14. The dye-sensitized solar cell module of claim 10, wherein:

   bubbles occurring in the unit cell are absent when the dye-sensitized solar cell module is stored in an oven at 85°C for 2 hours.

15. The dye-sensitized solar cell module of claim 10, wherein:

   a volume of the unit cell is V1, a volume of the electrolyte solution interposed in the unit cell is V2, and V1 and V2 satisfy Equation 1 below:

   [Equation 1]

$$1 < V2/V1 \leq 1.5.$$

16. A dye-sensitized solar cell comprising the dye-sensitized solar cell module of any one of claims 1 to 15.

## FIG. 1

# FIG. 2

## FIG. 3

No bubbles occurred after being
stored in oven at 85℃ for 2 hours

# FIG. 4

## FIG. 5

Injection of electrolyte solution

Cell

# FIG. 6

Europäisches
Patentamt

European
Patent Office

Office européen
des brevets

# EUROPEAN SEARCH REPORT

Application Number

EP 17 21 1133

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | EP 2 175 516 A1 (SONY CORP [JP]) 14 April 2010 (2010-04-14) * paragraph [0056] - paragraph [0061]; figure 1 * ----- | 1-16 | INV. H01G9/20 |
| X | WO 2010/005213 A2 (DONGJIN SEMICHEM CO LTD [KR]; PARK TAE-JIN [KR]; MOON HYOUNG-DON [KR];) 14 January 2010 (2010-01-14) * paragraph [0078] - paragraph [0136]; figures 1-11 * ----- | 1-16 | |

TECHNICAL FIELDS
SEARCHED       (IPC)

H01G

The present search report has been drawn up for all claims

| Place of search | Date of completion of the search | Examiner |
|---|---|---|
| The Hague | 23 May 2018 | Konrádsson, Ásgeir |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

 .......................................................................................
& : member of the same patent family, corresponding
    document

EPO FORM 1503 03.82 (P04C01)

## ANNEX TO THE EUROPEAN SEARCH REPORT
## ON EUROPEAN PATENT APPLICATION NO.

EP 17 21 1133

This annex lists the patent family members relating to the patent documents cited in the above-mentioned European search report.
The members are as contained in the European Patent Office EDP file on
The European Patent Office is in no way liable for these particulars which are merely given for the purpose of information.

23-05-2018

| Patent document cited in search report | | Publication date | Patent family member(s) | | Publication date |
|---|---|---|---|---|---|
| EP 2175516 | A1 | 14-04-2010 | CN | 101595594 A | 02-12-2009 |
| | | | EP | 2175516 A1 | 14-04-2010 |
| | | | JP | 5023866 B2 | 12-09-2012 |
| | | | JP | 2009032547 A | 12-02-2009 |
| | | | KR | 20100038077 A | 12-04-2010 |
| | | | US | 2010116340 A1 | 13-05-2010 |
| | | | WO | 2009016869 A1 | 05-02-2009 |
| WO 2010005213 | A2 | 14-01-2010 | NONE | | |

EPO FORM P0459

For more details about this annex : see Official Journal of the European Patent Office, No. 12/82